(19) Europäisches Patentamt / European Patent Office / Office européen des brevets

(11) **EP 4 700 824 A1**

(12) **EUROPEAN PATENT APPLICATION**
published in accordance with Art. 153(4) EPC

(43) Date of publication:
**25.02.2026 Bulletin 2026/09**

(21) Application number: **24792656.1**

(22) Date of filing: **16.04.2024**

(51) International Patent Classification (IPC):
*H01L 21/52* [(2006.01)]      *H01B 1/00* [(2006.01)]
*H01B 1/22* [(2006.01)]

(52) Cooperative Patent Classification (CPC):
**H01B 1/00; H01B 1/22; H10W 72/071**

(86) International application number:
**PCT/JP2024/015092**

(87) International publication number:
**WO 2024/219382 (24.10.2024 Gazette 2024/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.04.2023 JP 2023068160**

(71) Applicants:
• **Daicel Corporation
Osaka-shi, Osaka 530-0011 (JP)**
• **The University of Osaka
Osaka 565-0871 (JP)**

(72) Inventors:
• **UESHIMA, Minoru
Tokyo 108-8230 (JP)**
• **CHEN, Chuantong
Suita-shi, Osaka 565-0871 (JP)**
• **LIU, Yang
Suita-shi, Osaka 565-0871 (JP)**

(74) Representative: **Grünecker Patent- und
Rechtsanwälte
PartG mbB
Leopoldstraße 4
80802 München (DE)**

(54) **LOW-TEMPERATURE-SINTERING BONDING MATERIAL AND BONDED STRUCTURE**

(57)      Provided is a low-temperature-sinterable bonding material which can be sintered at a low temperature when used for sintering bonding, which can provide a bonded structure having high reliability, and whose preparation is simple and easy. A low-temperature-sinterable bonding material according to an embodiment contains silver particles and silicon particles, greater than 50% of surfaces of the silicon particles being constituted by silicon atoms. A low-temperature-sinterable bonding material according to another embodiment contains silver particles and silicon particles, silver constituting the silver particles and silicon constituting the silicon particles forming an interface at an atomic level by sintering.

FIG. 1

EP 4 700 824 A1

## Description

Technical Field

The present invention relates to a low-temperature-sinterable bonding material used for bonding a semiconductor element and/or a heat dissipation board, and a bonded structure (bonded body). The present application claims priority to Japanese Patent Application No. 2023-068160 filed in Japan on April 18, 2023, the content of which is incorporated herein by reference.

Background Art

In a semiconductor device, in which an electronic component such as a semiconductor element is mounted on a metal substrate such as a copper substrate, the electronic component is fixed with solder. In recent years, in consideration of the burden on the environment and human body, transition from known lead-containing solder to lead-free solder has been progressing. In addition, recently, use of SiC chips, which have even better low-loss characteristics compared with widely used Si chips, as semiconductor chips has been considered. However, the operating temperature may be higher than 200°C for a semiconductor device in which a SiC chip is mounted on a substrate. Thus, solder having a high melting point is required to be used as solder for fixing the SiC chip on the substrate; however, lead-free solder having a high melting point is difficult to be obtained.

In recent years, sintering bonding has been studied for die-bonding (die-attaching) of a semiconductor element operating at a high temperature such as a SiC chip. In sintering bonding, a metal paste containing nanosized particles or microsized particles of silver or copper is used as a bonding material and the bonding material is sandwiched between objects to be bonded and is heated for a predetermined time period to sinter the metal such as silver in the bonding material to bond the objects to be bonded by a metal bonding layer (e.g., see Patent Document 1). Various applications of this metal bonding technique are expected for electronic elements such as power semiconductor elements and LED elements.

However, metals such as silver are too hard as a die attach material and the thermal expansivity difference between a semiconductor element made of Si, SiC or the like, and a metal layer such as silver is remarkably large, and thus satisfactory reliability is not achieved because a sintered part may crack and/or the aforementioned semiconductor element or an insulative substrate such as direct bonded copper (DBC) may break in thermal fatigue testing at higher than 200°C. Furthermore, when a bonding material is a single metal, improvement in bonding strength and/or heat resistance is only possible by a method of controlling tightness of sintering, and the mechanical properties of the bonded body cannot be changed essentially.

Furthermore, a low-temperature-sinterable bonding paste containing silver powder (A) and particles of an element, other than silver, covered with silver (B) has been known (see Patent Document 2). When the aforementioned low-temperature-sinterable bonding paste is used for sintering bonding, sintering is possible at a low temperature, and a bonded structure having high reliability can be obtained.

Citation List

Patent Document

Patent Document 1: JP 2011-80147 A
Patent Document 2: WO 2021/039874

Summary of Invention

Technical Problem

However, the low-temperature-sinterable bonding paste of Patent Document 2 requires preparation of particles of an element other than silver, the particles being covered with silver, and thus there is room for improvement for the production process of the low-temperature-sinterable bonding paste.

Thus, an object of the present disclosure is to provide a low-temperature-sinterable bonding material which can be sintered at a low temperature when used for sintering bonding, which can provide a bonded structure having high reliability, and whose preparation is simple and easy. Furthermore, another object of the present disclosure is to provide a bonded structure whose production is easy and which has high reliability.

Solution to Problem

As a result of diligent research to solve the problems described above, the inventors of the present disclosure found that, when a particular low-temperature-sinterable bonding material containing silver particles and silicon particles is used for sintering bonding, sintering can be performed at a low temperature while preparation is simple and easy, and a bonded structure having high reliability can be obtained. The invention of the present disclosure was completed based on these findings.

That is, the present disclosure provides a low-temperature-sinterable bonding material containing silver particles and silicon particles, greater than 50% of surfaces of the silicon particles being constituted by silicon atoms.

60% or greater of the silicon particles are preferably constituted by silicon atoms.

An average particle diameter of the silicon particles is preferably from 0.05 to 40 $\mu$m.

Silver constituting the silver particles and silicon constituting the silicon particles preferably form an interface at an atomic level by sintering.

An average particle diameter of the silver particles is preferably from 0.5 to 40 $\mu$m.

The silver particles are preferably in a flake shape.

The present disclosure also provides a low-temperature-sinterable bonding material containing silver particles and silicon particles, silver constituting the silver particles and silicon constituting the silicon particles forming an interface at an atomic level by sintering.

10% or greater of surfaces of the silicon particles preferably form the interface with the silver particles by the sintering.

40% or greater of surfaces of the silicon particles preferably form the interface with the silver particles by the sintering.

The present disclosure also provides a low-temperature-sinterable bonding material containing silver particles and silicon particles, an average particle diameter of the silicon particles being 1/20 or greater of an average particle diameter of the silver particles, and a content proportion of the silicon particles with respect to a total amount of the silver particles and the silicon particles being from 10 to 70 vol.%.

An average particle diameter of the silicon particles is preferably from 0.05 to 40 $\mu$m.

An average particle diameter of the silver particles is preferably from 0.1 to 50 $\mu$m.

The low-temperature-sinterable bonding material is preferably a paste or a sheet.

The present disclosure also provides a bonded structure, in which an object to be bonded is bonded to a substrate via a silver bonding layer containing a sintered body of the low-temperature-sinterable bonding material described above.

Advantageous Effects of Invention

According to the low-temperature-sinterable bonding material of the present disclosure, sintering can be performed at a low temperature while preparation is simple and easy, and a bonded structure having high reliability can be obtained. Thus, the resulting bonded structure is less likely to cause problems such as cracking of a sintered part, or cracking of a semiconductor element made of Si, SiC or the like, the semiconductor element being an object to be bonded, or a substrate such as DBC.

Brief Description of Drawings

    FIG. 1 is a cross-sectional view illustrating a bonded structure of an embodiment of the present disclosure.

    FIG. 2 is TEM images of a cross section of a bonded structure obtained in Example 1.

Description of Embodiments

Low-temperature-sinterable Bonding Material

The low-temperature-sinterable bonding material according to an embodiment of the present disclosure at least contains silver particles and silicon particles. For each of the silver particles and the silicon particles described above, only one type may be included or two or more types may be included.

Silver Particle

The average particle diameter (median diameter; D50) of the aforementioned silver particles is preferably from 0.1 to 50 $\mu$m, more preferably from 0.5 to 40 $\mu$m, even more preferably from 0.5 to 20 $\mu$m, and particularly preferably from 1 to 5 $\mu$m. When the aforementioned average particle diameter is 0.1 $\mu$m or greater, superior electrical conductivity is achieved for a sintered part formed by sintering. When the aforementioned average particle diameter is 50 $\mu$m or less, problems are less likely to occur such as cracking of a sintered part and cracking of a semiconductor element made of Si, SiC or the like, the semiconductor element being an object to be bonded, or a substrate such as DBC. The aforementioned average particle diameter of the silver particles can be measured by a laser diffraction/scattering method.

Furthermore, the specific surface area of the silver particles is preferably from 0.5 to 4.0 m$^2$/g, more preferably from 0.6 to 3.0 m$^2$/g, even more preferably from 0.7 to 2.5 m$^2$/g, and particularly preferably from 0.8 to 2.0 m$^2$/g. Note that the specific surface area of the silver particles can be measured by a BET method.

Examples of the shape of the silver particle include a spherical shape, a flake shape (flat shape), and a polyhedral shape. Silver particles having different shapes may be used in combination, or only silver particles having the same shape may be used. The shape of the silver particle is preferably a flake shape. When flake-shaped silver particles are used, a large amount of crystal grain boundary at the time of flake formation is contained in the particles, coarsening of the crystals is promoted at the time of heating, and an effect of promoting the sintering is achieved.

When flake-shaped silver particles are used as the form of the silver particles, the average diameter thereof is preferably from 0.5 to 10 $\mu$m, more preferably from 2 to 8 $\mu$m, and even more preferably from 3 to 7 $\mu$m. In addition, when flake-shaped silver particles are used, the average thickness thereof is preferably from 30 nm to 2 $\mu$m, more preferably from 80 nm to 1 $\mu$m, and even more preferably from 100 nm to 700 nm. In addition, when flake-shaped silver particles are used, the aspect ratio thereof is preferably from 3 to 70, more preferably from 5 to 50, and even more preferably from 7 to 20.

As the silver particles, a commercially available product may be used and, for example, the trade name "AgC-239" (available from Fukuda Metal Foil & Powder Co., Ltd.) and the like can be used.

Silicon Particle

The silicon particles are particles containing silicon atoms as a constituent. The proportion of the silicon atoms in the silicon particles is preferably 50% or greater (e.g., 50 to 100%), more preferably 60% or greater, even more preferably 70% or greater, yet even more preferably 80% or greater, yet even more preferably 90% or greater, and particularly preferably 95% or greater.

Greater than 50% of the surfaces of the silicon particles are preferably constituted by silicon atoms. That is, the proportion of the silicon atoms occupying the silicon particle surfaces in the silicon particles is preferably 50% or greater (e.g., 50 to 100%), more preferably 60% or greater, even more preferably 70% or greater, yet even more preferably 90% or greater, and particularly preferably 95% or greater. The proportion R (%) of the silicon atoms occupying the silicon particle surfaces can be determined as a proportion of a Si layer occupying a powder surface based on a cross-sectional image of a particle taken by an SEM observation of a cross section of a powder particle at a magnification of 1000 to 10000 times.

In a case where a silicon particle having a surface covered with Ag is used before sintering, an interface (condition in which Ag and Si are not mixed but bonded) between Ag and Si is not formed at an atomic level, and Ag coating, covering a silicon particle surface, covers a silicon particle, and thus opportunity of direct contact between the silver particles that have been activated during a sintering process and the silicon particle surface is reduced, and thus interface formation at an atomic level of the Ag and the silicon particle is inhibited. Furthermore, the Ag coating the surface of the silicon particle intensely undergoes atomic diffusion of the Ag coating parts during sintering, and the Ag coating is coarsened and granulates before forming an interface with the silicon particle. Although the Ag has covered the silicon particle before the sintering, the Ag that covered the silicon particle results in being released from the silicon particle during the sintering. On the other hand, by using a silicon particle in which greater than 50% of the surface is constituted by silicon atoms, the silver constituting the silver particles and the silicon constituting the silicon particles form an interface at an atomic level after the sintering, and the releasing of the Ag from the silicon particle can be suppressed.

With an Ag coating technique for a silicon particle by using a ball mill, it is difficult to form the interface between the Ag and the Si at an atomic level. However, by not covering the silicon particle with the silver in advance but by allowing the silver particles activated at approximately 300°C, which is a low temperature, in a sintering process to directly react with the silicon particle, an interface between the Ag and the silicon particle at an atomic level can be formed.

The average particle diameter (median diameter; D50) of the silicon particles is preferably from 0.05 to 40 $\mu$m, more preferably from 0.01 to 30 $\mu$m, even more preferably from 1 to 20 $\mu$m, and particularly preferably from 5 to 15 $\mu$m. When the aforementioned average particle diameter is in the range described above, problems are less likely to occur such as cracking of a sintered part and cracking of a semiconductor element made of Si, SiC or the like, the semiconductor element being an object to be bonded, or a substrate such as DBC. The aforementioned average particle diameter of the silicon particles can be measured by a laser diffraction/scattering method.

Examples of the shape of the silicon particle include a spherical shape, a flake shape (flat shape), and a polyhedral shape. Silicon particles having different shapes may be used in combination, or only silicon particles having the same shape may be used. The shape of the silicon particle is preferably a spherical shape or a polyhedral shape from the perspective of maintaining uniform dispersibility of the present particles in a paste application process during formation of a bonded part. In particular, thermal conductivity of a bonded member is significantly important in the bonded part of a semiconductor or heat sink of a power device, and thus a shape having a small surface area per volume is preferred to suppress reduction in thermal conductivity for silicon particles having lower thermal conductivity than that of the silver particles and, ideally, a spherical shape is preferred.

As the silicon particles, a commercially available product, such as commercially available silicon particles that are not surface-treated or commercially available silicon particles in which 50% or less of the area proportion of the particle surfaces are surface-treated, may be used. In addition, for example, powder obtained by pulverizing a commercially available Si ingot in a size of approximately several mm by using a ball mill can be used.

The average particle diameter of the silicon particles is preferably 1/20 or greater, more preferably 1/10 or greater, and even more preferably 1/3 or greater, of the average particle diameter of the silver particles. When the aforementioned average particle diameter of the silicon atoms is 1/20 or greater, in addition to the sintering of the silver particles and the silicon particles, sintering between the silver particles is also not inhibited and forms a heat dissipating electrically conductive path, and sintering between the silver particles forming a trick between the bonded parts is promoted, and thus good bonding condition can be achieved. Note that, in a case where the particle described above is not spherical and, for example, is in a flake shape, a value obtained by calculating a volume based on an average diameter assuming that the flake particle is a disc shape and a thickness thereof and converting the volume into a volume as a sphere is used as an average diameter.

In the silver particles and the silicon particles, the silver constituting the silver particles and the silicon constituting the silicon particles preferably form an interface at an atomic level by sintering. By the formation of such an interface, the interface between Ag and Si becomes stable and interfacial delamination can be suppressed in a case where stress occurs in a bonded part due to environmental change. The interface described above is formed on preferably 10% or greater, more preferably 20% or greater, and even more preferably 40% or greater, of the surface of the silicon particles described above. For the formation of the interface described above, for example, observation is performed by using a field emission-scanning electron microscope (FE-SEM) at a magnification of 50000 times and then a representative interface is observed by using a TEM at a magnification of 100000 times, and formation of an interface at an atomic level can be confirmed when no gap that is equal to or greater than 1 nm was observed between Si and Ag in the interface or when no gap that is equal to or greater than 1 nm between Si and Ag sandwiching a metal layer or oxide phase containing Ag or Si as a main component was observed. Furthermore, the proportion of the silicon particle surface forming the interface described above can be measured by observing a cross section of a bonded part by using an FE-SEM, observing a representative interface by using a TEM, confirming formation of an Ag/Si interface at an atomic level, then checking an entire image of the silicon particle by using an FE-SEM, and manually measuring an area of an Ag-Si interface having no gap that is equal to or greater than 10 nm at a magnification that can confirm a 10 nm gap, such as a magnification of 20000 times or greater.

The content proportion of the silicon particles with respect to the total amount of the silver particles and the silicon particles is preferably from 10 to 70 vol.%, more preferably from 20 to 50 vol.%, and even more preferably from 30 to 40 vol.%. When the aforementioned content proportion is 10% or greater, problems are less likely to occur such as cracking of a sintered part and cracking of a semiconductor element made of Si, SiC or the like, the semiconductor element being an object to be bonded, or a substrate such as DBC. When the aforementioned content proportion is 70% or less, superior electrical conductivity is achieved for a sintered part formed by sintering. Specifically, when the aforementioned content proportion is 70 vol.% or less, a relatively adequate amount of an Ag network structure of a sintering-bonded part can be ensured, extremely superior bonding strength is achieved, a heat dissipating path through the Ag layer can be adequately ensured, and excellent thermal conductivity is also achieved.

The aforementioned low-temperature-sinterable bonding material may contain electrically conductive particles other than the silver particles and the silicon particles (hereinafter, may be also referred to as "additional electrically conductive particles"). The total content proportion of the silver particles and the silicon particles is, for example, 75 mass% or greater, preferably 80 mass% or greater, more preferably 85 mass% or greater, even more preferably 90 mass% or greater, and particularly preferably 95 mass% or greater, with respect to the total amount of the electrically conductive particles contained in the aforementioned low-temperature-sinterable bonding material. When the silver particles and the silicon particles are contained in the range described above, a bonded structure having particularly excellent electrical properties can be formed.

The form of the low-temperature-sinterable bonding material described above is not particularly limited, and examples thereof include a composition containing a solvent or an organic component such as a binder component (low-temperature-sinterable bonding ink composition) and a sheet-like material (low-temperature-sinterable bonding sheet).

The aforementioned low-temperature-sinterable bonding ink composition is not particularly limited and may be in various forms. For example, an ink composition, which is called a metal ink, can be prepared by dispersing the silver particles and the silicon particles in an appropriate solvent (dispersion medium, especially an organic solvent) in a suspended state. Alternatively, an ink composition, which is called a paste, (low-temperature-sinterable bonding paste) can be prepared by dispersing the silver particles and the silicon particles in a solvent in a kneaded state.

In the low-temperature-sinterable bonding paste described above, the total content proportion of the silver particles and the silicon particles is preferably from 75 to 95 mass%, more preferably from 80 to 93 mass%, and even more preferably from 85 to 90 mass%, with respect to the total amount of the low-temperature-sinterable bonding paste.

Solvent

The aforementioned low-temperature-sinterable bonding ink composition typically contains a solvent. As the solvent, a solvent that is ordinarily used in an electrically conductive paste can be used. Examples of the solvent include dipropylene glycol mono $C_{1-6}$ alkyl ethers, such as dipropylene glycol monomethyl ether, dipropylene glycol monoethyl ether, dipropylene glycol monopropyl ether, dipropylene glycol monoisopropyl ether, dipropylene glycol monobutyl ether, dipropylene glycol monoisobutyl ether, dipropylene glycol monopentyl ether, and dipropylene glycol monoisopentyl ether; and dipropylene glycol di $C_{1-6}$ alkyl ethers, such as dipropylene glycol dimethyl ether, dipropylene glycol methylethyl ether, dipropylene glycol methylpropyl ether, dipropylene glycol methylbutyl ether, dipropylene glycol methylisobutyl ether, dipropylene glycol methylpentyl ether, dipropylene glycol methylisopentyl ether, dipropylene glycol diethyl ether, dipropylene glycol ethylpropyl ether, dipropylene glycol ethylbutyl ether, dipropylene glycol ethylisobutyl ether, dipropylene glycol ethylpentyl ether, dipropylene glycol ethylisopentyl ether, dipropylene glycol dipropyl ether, dipropylene glycol propylbutyl ether, dipropylene glycol propylisobutyl ether, dipropylene glycol propylpentyl ether, dipropylene glycol propylisopentyl ether, dipropylene glycol dibutyl ether, dipropylene glycol diisobutyl ether, dipropylene glycol butylisobutyl ether, dipropylene glycol butylpentyl ether, dipropylene glycol butylisopentyl ether, dipropylene glycol isobutylpentyl ether, dipropylene glycol isobutylisopentyl ether, dipropylene glycol dipentyl ether, and dipropylene glycol pentylisopentyl ether (including isomers).

Examples of the solvent described above also include tripropylene glycol mono $C_{1-6}$ alkyl ethers, such as tripropylene glycol monomethyl ether, tripropylene glycol monoethyl ether, tripropylene glycol monopropyl ether, tripropylene glycol monoisopropyl ether, tripropylene glycol monobutyl ether, tripropylene glycol monoisobutyl ether, tripropylene glycol monopentyl ether, and tripropylene glycol monoisopentyl ether; and tripropylene glycol di $C_{1-6}$ alkyl ethers, such as tripropylene glycol dimethyl ether, tripropylene glycol methylethyl ether, tripropylene glycol methylpropyl ether, tripropylene glycol methylbutyl ether, tripropylene glycol methylisobutyl ether, tripropylene glycol methylpentyl ether, tripropylene glycol methylisopentyl ether, tripropylene glycol diethyl ether, tripropylene glycol ethylpropyl ether, tripropylene glycol ethylbutyl ether, tripropylene glycol ethylisobutyl ether, tripropylene glycol ethylpentyl ether, tripropylene glycol ethylisopentyl ether, tripropylene glycol dipropyl ether, tripropylene glycol propylbutyl ether, tripropylene glycol propylisobutyl ether, tripropylene glycol propylpentyl ether, tripropylene glycol propylisopentyl ether, tripropylene glycol dibutyl ether, tripropylene glycol diisobutyl ether, tripropylene glycol butylisobutyl ether, tripropylene glycol butylpentyl ether, tripropylene glycol butylisopentyl ether, tripropylene glycol isobutylpentyl ether, tripropylene glycol isobutylisopentyl ether, tripropylene glycol dipentyl ether, and tripropylene glycol pentylisopentyl ether (including isomers).

In addition, examples of the solvent described above include ethylene glycol mono $C_{1-6}$ alkyl ethers, such as ethylene glycol monomethyl ether, ethylene glycol monoethyl ether, ethylene glycol monopropyl ether, ethylene glycol monoisopropyl ether, ethylene glycol monobutyl ether, ethylene glycol monoisobutyl ether, and ethylene glycol monohexyl ether; ethylene glycol di $C_{1-6}$ alkyl ethers, such as ethylene glycol methyl-n-propyl ether, ethylene glycol methyl-n-butyl ether, and ethylene glycol methylisoamyl ether; diethylene glycol mono $C_{1-6}$ alkyl ethers, such as diethylene glycol monomethyl ether, diethylene glycol monoethyl ether, diethylene glycol monoisopropyl ether, and diethylene glycol monobutyl ether; diethylene glycol di $C_{1-6}$ alkyl ethers, such as diethylene glycol dimethyl ether, diethylene glycol diethyl ether, diethylene glycol ethylmethyl ether, diethylene glycol isopropylmethyl ether, and diethylene glycol methyl-n-butyl ether; triethylene glycol mono $C_{1-6}$ alkyl ethers, such as triethylene glycol monomethyl ether and triethylene glycol monobutyl ether; and triethylene glycol di $C_{1-10}$ alkyl ethers, such as triethylene glycol methyl-n-butyl ether (including isomers).

In addition, examples of the solvent described above include $C_{2-3}$ alkylene glycol $C_{1-6}$ alkyl ether $C_{1-10}$ alkyl esters, such as ethylene glycol monomethyl ether acetate, ethylene glycol monobutyl ether acetate, and propylene glycol monomethyl ether acetate; di $C_{2-3}$ alkylene glycol $C_{1-6}$ alkyl ether $C_{1-10}$ alkyl esters, such as diethylene glycol-n-butyl ether acetate, diethylene glycol ethyl ether acetate, diethylene glycol butyl ether acetate, and dipropylene glycol methyl ether acetate; tri $C_{2-3}$ alkylene glycol $C_{1-6}$ alkyl ether $C_{1-10}$ alkyl esters, such as triethylene glycol-n-butyl ether acetate, triethylene glycol ethyl ether acetate, triethylene glycol butyl ether acetate, and tripropylene glycol methyl ether acetate; and $C_{2-3}$ alkylene glycol di $C_{1-10}$ alkyl esters, such as propylene glycol diacetate (including isomers).

In addition, for example, ethyl lactate acetate, tetrahydrofurfuryl acetate, tetrahydrofurfuryl alcohol, or ethylene glycol can be also used as the solvent described above.

A single type of the solvent described above may be used, or two or more types thereof may be used.

In the low-temperature-sinterable bonding paste, the content of the solvent is preferably from 1 to 50 parts by mass, more preferably from 2 to 40 parts by mass, and even more preferably from 3 to 35 parts by mass, with respect to 100 parts by mass total of the silver particles and the silicon particles.

The low-temperature-sinterable bonding ink composition described above may contain an organic additive, such as an adhesive, a thickener, or a binder.

The low-temperature-sinterable bonding sheet described above may be a sheet that has a network structure made of a metal component including silver and silicon and that can maintain a sheet state only by the metal component and the silicon component, or may be a sheet in which metal particles are dispersed in a resin and the resin component maintains a sheet state.

The low-temperature-sinterable bonding sheet described above has a region having sinterability on at least one face. The aforementioned low-temperature-sinterable bonding sheet may contain a gap in the vicinity of a surface. In this case, the porosity in the vicinity of the surface of the low-temperature-sinterable bonding sheet described above (especially, porosity in the vicinity of the surface of the sinterable region) is preferably 20% or less, more preferably 10% or less, and even more preferably 5% or less. When the aforementioned porosity is 20% or less, even better bonding properties can be exhibited.

The aforementioned porosity in the vicinity of the surface can be determined by exposing a cross section of the low-temperature-sinterable bonding sheet described above, observing a low-temperature-sinterable bonding sheet cross section in the vicinity of the edge in the thickness direction (e.g., 5% inner part (e.g., 2 μm inner part) of the low-temperature-sinterable bonding sheet thickness from the low-temperature-sinterable bonding sheet surface) by using a scanning electron microscope, calculating occupancy of the metal and the silicon by analyzing the obtained cross-sectional image, and performing calculation based on the following equation. Note that, in a case where a boundary between the vicinity of the surface and the inner part of the low-temperature-sinterable bonding sheet can be visually recognized based on the difference of the porosities, the porosity in the vicinity of the surface can be measured in a region that can be distinguished from the inner part described above regardless of the distance from the surface.

$$\text{Porosity [\%]} = 100 - \text{occupancy [\%]}$$

The aforementioned low-temperature-sinterable bonding sheet may contain a gap in the inner part. In this case, the porosity of the inner part of the low-temperature-sinterable bonding sheet described above is preferably 50% or less, more preferably 30% or less, even more preferably 20% or less, and particularly preferably 10% or less. When the aforementioned porosity described above is 50% or less, cracking or breakage is less likely to occur during handling due to mechanical strength.

The aforementioned porosity of the inner part can be determined by exposing a cross section of the low-temperature-sinterable bonding sheet described above, observing a low-temperature-sinterable bonding sheet cross section in the vicinity of the central part in the thickness direction by using a scanning electron microscope, calculating occupancy of the metal and the silicon by analyzing the obtained cross-sectional image, and performing calculation based on the following equation.

$$\text{Porosity [\%]} = 100 - \text{occupancy [\%]}$$

The low-temperature-sinterable bonding sheet described above can be produced by, for example, applying heat and/or pressure to a composition containing silver particles and silicon particles to melt surfaces of the metal particles containing the silver particles and/or the silicon atoms to fuse the particles to form a network. At this time, by adjusting the particle size of the particles, the temperature at the time of heating, the pressure at the time of pressurizing, the duration of heating and pressurizing, and the like, porosity in the inner part of the low-temperature-sinterable bonding sheet can be adjusted. Only one of the heating or the pressurizing described above may be performed, or both of the heating and the pressurizing may be performed. In a case where both of the heating and the pressurizing are performed, both may be performed simultaneously or sequentially. The temperature at the time of the heating described above is, for example, from 180 to 400°C. The pressure at the time of pressurizing described above is, for example, from 0.3 to 40 MPa.

Bonded Structure

The low-temperature-sinterable bonding material described above can be used for forming an electrically conductive layer such as metal wiring on a member to be bonded or can be used for bonding members to be bonded. For example, a bonded structure including an electrically conductive layer (bonding layer) on a member to be bonded can be obtained by applying the low-temperature-sinterable bonding ink composition described above onto a surface of the member to be bonded, optionally volatilizing a solvent by heating or the like, and then sintering (firing) metal particles containing silver particles by heating, pressurizing, irradiating with an active energy ray, or the like. In addition, for example, a bonded structure (bonded body) including an electrically conductive layer (bonding layer) on a member to be bonded can be obtained by placing the low-temperature-sinterable bonding sheet described above on the member to be bonded in a manner that the sinterable region described above of the low-temperature-sinterable bonding sheet is in contact with a surface of the member to be bonded, and sintering (firing) metal of the sinterable region by heating, pressurizing, irradiating with an active energy ray, or the like to bond the low-temperature-sinterable bonding sheet and the member to be bonded.

In addition, a bonded structure, in which a first member to be bonded and a second member to be bonded are bonded via a bonding layer, can be obtained by layering a low-temperature-sinterable bonding material between the first member to be bonded and the second member to be bonded, and then sintering (firing) metal particles containing silver particles. Furthermore, a metal metallization layer is preferably formed on a surface of the member to be bonded that is bonded with the low-temperature-sinterable bonding sheet described above. The metal constituting the metal metallization layer described above is preferably silver.

Examples of the member to be bonded described above include a substrate and a semiconductor chip. For example, a substrate can be used as a first member to be bonded, and a semiconductor chip can be used as a second member to be bonded.

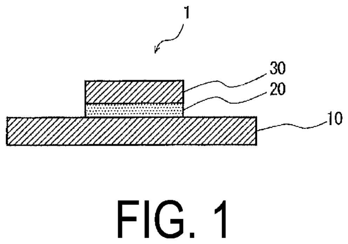

FIG. 1 illustrates a bonded structure of an embodiment of the present disclosure. In the bonded structure 1 illustrated in FIG. 1, a member 30 to be bonded is bonded to a substrate 10 via a silver bonding layer 20 containing a sintered body of the low-temperature-sinterable bonding material described above.

As the substrate described above, a known substrate that is commonly used for providing the bonding layer described above can be used. The substrate described above may be an electrically conductive substrate, an electrically non-conductive substrate, or a dielectric substance. The substrate described above may consist of a single layer only, or may include multiple layers, in which a plurality of layers is laminated.

Examples of the material forming the electrically non-conductive substrate described above include resins, glass, ceramics, wood, and paper. Examples of the resin described above include, in addition to heat-resistant plastics such as polyimide-based resins, polycarbonate-based resins, isocyanate-based resins, melamine-based resins, and glass epoxy resins, resins having low heat resistance including polyester-based resins such as polyethylene terephthalate (PET) and polyethylene naphthalate (PEN), polyolefin-based resins such as polyethylene and polypropylene, acrylic resins, epoxy-based resins, phenolic resins, and polyamide resins, as well as polychlorinated biphenyl (PCB), liquid crystal polymers (LCP), vinyl chloride, mold resins, and epoxy resins.

Examples of the electrically conductive substrate described above include metal substrates, such as metal foil and metal plates each made of a metal (e.g., copper, iron, and alloys of these); carbon substrates, such as carbon cloth, carbon paper, and graphite; composite substrates, such as electrically conductive particle-containing films, metal mesh films, metal-plated coated films, and optical laminates each having a transparent electrically conductive layer; resin substrates, such as electrically conductive macromolecular films; metal wire-containing films; and metal film laminates (e.g., printed-circuit boards), in which a metal (e.g., silver, copper) film is included on a part of or the whole electrically non-conductive substrate.

Examples of the substrate described above include semiconductor elements, such as metal substrates such as copper substrates, ceramic substrates, SiC substrates, gallium nitride substrates, glass epoxy substrates, BT resin substrates, glass substrates, resin substrates, IGBT, diodes, Schottky barrier diodes, MOSFET, thyristors, logic circuits, sensors, analog integrated circuits, LED, semiconductor lasers, and transmitters; substrates for mounting semiconductor elements, such as lead frames, metal plate-bonded ceramic substrates (e.g., DBC), piezoelectric ceramics, semiconductor packages, and LED packages; power supplying components, such as copper ribbons, metal blocks, and terminals; heat sinks; water cooling plates; lenses of glasses and sunglasses; glass (glass for vehicles, such as windshields, side windshields, and rear windshields of a vehicle); sensor covers; thermal transfer rollers; printed-circuit boards; vias of printed-circuit boards; displays for personal computers and televisions; road mirrors; signals; smartphones; wearable devices, such as watches and earphones; writing materials; slide glass; and office-automation equipment, such as mouses.

In a case where the low-temperature-sinterable bonding paste described above is used, production can be performed by forming a coating layer by applying the low-temperature-sinterable bonding paste to a substrate by a printing method (specifically, dispenser printing method, mask printing, screen printing method, inkjet printing method, and the like), placing a member 30 to be bonded onto the coating layer, and then sintering.

The sintering temperature of the coating layer described above is, for example, 150°C or higher and lower than 300°C, preferably from 160 to 280°C, more preferably from 200 to 270°C, and even more preferably from 230 to 260°C. Furthermore, the sintering time is, for example, from 0.1 to 2 hours, and preferably from 0.5 to 1.5 hours.

In a case where the low-temperature-sinterable bonding sheet described above is used, the temperature at the time of sintering (sintering temperature) is, for example, 500°C or lower, preferably 300°C or lower, more preferably 250°C or lower, and even more preferably room temperature (e.g., 25°C) or higher and 150°C or lower. When the sintering temperature is 300°C or lower (especially, 250°C or lower), even in a case where the substrate is a material easily thermally deformed, thermal deformation can be suppressed. In particular, when sintering of a metal is preferably completed by sintering in a short time period, the sintering is preferably performed at, for example, from 60 to 200°C, preferably from 70 to 180°C, more preferably from 80 to 150°C, and even more preferably from 90 to 120°C. The sintering time may be properly decided taking the type of metal particles, the application amount, the sintering temperature, and the like into consideration and is, for example, within some hours (e.g., from 40 seconds to 33 hours), preferably within 1 hour, more preferably within 50 minutes, even more preferably from 10 to 40 minutes, and particularly preferably from 15 to 30 minutes.

The thickness of the low-temperature-sinterable bonding material described above is in a range that makes the thickness of the bonded structure formed by the method described above, for example, from 15 to 400 $\mu$m, preferably from 20 to 250 $\mu$m, and more preferably from 40 to 180 $\mu$m.

The sintering described above may be performed in an air atmosphere or may be performed in an inert gas atmosphere such as a nitrogen atmosphere or an argon atmosphere.

Examples of the second member to be bonded (member 30 to be bonded) include an electronic component and a heat dissipation board. Examples of the electronic component include electronic elements (chip, die) such as a power semiconductor element and an LED element. The bonded face between the member 30 to be bonded and the silver bonding layer 20 is preferably silver-plated. The material of the member 30 to be bonded may be any of silicon (Si) or silicon carbide (SiC); however, an excellent effect is achieved especially in the case where the material is silicon carbide (SiC).

Examples of the bonded structure described above include electric and electronic devices, such as electromagnetic wave control materials, circuit boards, antennas, heat sinks, liquid crystal displays, organic EL displays, field emission displays (FED), IC cards, IC tags, solar cells, LED elements, organic transistors, condensers (capacitors), electronic paper, flexible batteries, flexible sensors, membrane switches, touch screens, and EMI shields.

According to the low-temperature-sinterable bonding material of the present disclosure, because a sintering-bonded part made of an Ag-Si alloy is formed by sintering, mechanical properties (strength and coefficient of thermal expansion) of the bonded part can be changed. Thus, the properties such as thermal fatigue resistance of the bonded part can be essentially improved. Furthermore, a large amount of the silicon particles, which are difficult to be dispersed in silver, are dispersed in the bonded part, the solid-phase diffusion of the silver is blocked by the silicon particles, and structure coarsening of the metal layer can be suppressed due to stress relaxation of the bonded part caused by the silicon particle addition.

Each aspect disclosed in the present description can be combined with another feature disclosed in the present description. The configurations, combinations thereof, and the like in each embodiment are exemplary, and additions, omissions, replacements, and other changes of the configurations can be appropriately made without departing from the spirit of the present disclosure. In addition, each of the inventions according to the present disclosure is not limited by the embodiments or the following examples but is limited only by the claims.

Example

An embodiment of the present disclosure will be described in more detail below based on Examples. Hereinafter, an average particle diameter (median diameter) of particles is a value measured by a laser diffraction/scattering method.

The used raw materials are as follows.

Silver Flake Powder (Silver Flake Particle)

- Trade name "AgC-239": average diameter: 5.0 μm; average thickness: 260 nm; specific surface area: 1.2 m²/g; available from Fukuda Metal Foil & Powder Co., Ltd.

Silicon (Si) Particle

- Trade name "Metal Silicon Powder": Si purity: > 98.9%; particle size: D50 = 32.8 μm

Solvent

- Trade name "DPNP": dipropylene glycol n-propyl ether: boiling point: 212°C; available from Daicel Corporation

Comparative Example 1

By using high-speed three-dimensional motion (strong frictional motion) of a three-dimensional ball mill (trade name "3D Ball Mill"), available from Nagao System K.K., 53 parts by mass of silver flake powder (trade name "AgC-239") and 47 parts by mass of silicon (Si) particles (trade name "Metal Silicon Powder") were mixed and pulverized, and thus silicon (Si) particles having surfaces covered with silver were obtained. For this silicon (Si) particle having the surface covered with the silver, when the proportion of the silver coating layer occupying the particle surface was calculated based on an image taken by an SEM at a magnification of 3000 times, the proportion was 72%. Hereinafter, these silicon (Si) particles having surfaces covered with the silver may be referred to as "Si-20 vol.% Ag particles".

To 100 parts by mass of the "Si-20 vol.% Ag particles" described above, 21 parts by mass of a solvent (trade name "DPNP") was added and mixed, and thus "Si-Ag paste-1" was obtained. This paste had a viscosity appropriate for use as a bonding paste.

On a silver-plated copper substrate (10 mm × 100 mm × thickness 2 mm), the "Si-Ag paste-1" was printed by using a metal mask to form a coating film having a thickness of approximately 100 μm, and then a Si die having a back face covered with silver (3 mm × 3 mm × thickness 0.45 mm) was mounted on this paste coating film.

The obtained test sample (bonded structure) having a layer structure of Si die/Si-Ag paste/copper substrate was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 μm/s) between the Si die and the copper substrate was measured by using a die shear tester (trade name "XD-7500", available from DAGE). The result showed that the shear strength was 2.9 N.

Comparative Example 2

By using high-speed three-dimensional motion (strong frictional motion) of a three-dimensional ball mill (trade name "3D Ball Mill"), available from Nagao System K.K., 75 parts by mass of silver flake powder (trade name "AgC-239") and 25 parts by mass of silicon (Si) particles (trade name "Metal Silicon Powder") were mixed and pulverized, and thus silicon (Si) particles having surfaces covered with silver were obtained. For this silicon (Si) particle having the surface covered with the silver, when the proportion of the silver coating layer occupying the particle surface was determined by the method the same as that in Comparative Example 1, the proportion was 92%. Hereinafter, these silicon (Si) particles having surfaces covered with the silver may be referred to as "Si-40 vol.% Ag particles".

To 100 parts by mass of the "Si-40 vol.% Ag particles" described above, 25 parts by mass of a solvent (trade name "DPNP") was added and mixed, and thus "Si-Ag paste-2" was obtained. This paste had a viscosity appropriate for use as a bonding paste.

By using the "Si-Ag paste-2" described above, a test sample (bonded structure) having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 $\mu$m/s) between the Si die and the copper substrate was measured in the same manner as in Comparative Example 1, and the shear strength was 13 N.

Comparative Example 3

By using high-speed three-dimensional motion (strong frictional motion) of a three-dimensional ball mill (trade name "3D Ball Mill"), available from Nagao System K.K., 87.2 parts by mass of silver flake powder (trade name "AgC-239") and 12.8 parts by mass of silicon (Si) particles (trade name "Metal Silicon Powder") were mixed and pulverized, and thus silicon (Si) particles having surfaces covered with silver were obtained. For these silicon (Si) particles having the surface covered with the silver, when the proportion of the silver coating layer occupying the particle surface was determined by the method the same as that in Comparative Example 1, the proportion was 98%. Hereinafter, these silicon (Si) particles having surfaces covered with the silver may be referred to as "Si-60 vol.% Ag particles".

To 100 parts by mass of the "Si-60 vol.% Ag particles" described above, 30 parts by mass of a solvent (trade name "DPNP") was added and mixed, and thus "Si-Ag paste-3" was obtained. This paste had a viscosity appropriate for use as a bonding paste.

By using the "Si-Ag paste-3" described above, a test sample (bonded structure) having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 $\mu$m/s) between the Si die and the copper substrate was measured in the same manner as in Comparative Example 1, and the shear strength was 23 N.

Comparative Example 4 (Ag:Si = 66:34 vol.% = 90:10 mass%)

80 parts by mass of the "Si-60 vol.% Ag particles" obtained in Comparative Example 3, 20 parts by mass of silver flake powder (trade name "AgC-239"), and 20 parts by mass of a solvent (trade name "DPNP") were added and mixed, and thus "Si-Ag paste-4" was obtained. This paste had a viscosity appropriate for use as a bonding paste.

By using the "Si-Ag paste-4" described above, a test sample (bonded structure) having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 $\mu$m/s) between the Si die and the copper substrate was measured in the same manner as in Comparative Example 1, and the shear strength was 43 N.

Comparative Example 5 (Ag:Si = 73:27 vol.% = 92:8 mass t%)

60 parts by mass of the "Si-60 vol.% Ag particles" obtained in Comparative Example 3, 40 parts by mass of silver flake powder (trade name "AgC-239"), and 20 parts by mass of a solvent (trade name "DPNP") were added and mixed, and thus "Si-Ag paste-5" was obtained. This paste had a viscosity appropriate for use as a bonding paste.

By using the "Si-Ag paste-5" described above, a test sample (bonded structure) having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 $\mu$m/s) between the Si die and the copper substrate was measured in the same manner as in Comparative Example 1, and the shear strength was 84 N.

Comparative Example 6 (Ag:Si = 80:20 vol.% = 95:5 mass%)

40 parts by mass of the "Si-60 vol.% Ag particles" obtained in Comparative Example 3, 60 parts by mass of silver flake powder (trade name "AgC-239"), and 20 parts by mass of a solvent (trade name "DPNP") were added and mixed, and thus "Si-Ag paste-6" was obtained. This paste had a viscosity appropriate for use as a bonding paste.

By using the "Si-Ag paste-6" described above, a test sample (bonded structure) having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 $\mu$m/s) between the Si die and the copper substrate was measured in the same manner as in Comparative Example 1, and the shear strength was 146 N.

Example 1

94.6 parts by mass of silver flake powder (trade name "AgC-239") and 5.4 parts by mass of silicon (Si) particles (trade name "Metal Silicon Powder") were mixed. Then, with respect to 100 parts by mass of the powder mixture, 25 parts by mass of a solvent (trade name "DPNP") was added and mixed, and thus "Si-Ag paste-1A" was obtained. This paste had a viscosity appropriate for use as a bonding paste.

By using the "Si-Ag paste-1A" described above, a test sample (bonded structure) having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 $\mu$m/s) between the Si die and the copper substrate was measured in the same manner as in Comparative Example 1, and the shear strength was 250 N. As described above, Example 1 exhibited a high shear strength compared to Comparative Example 6 having the same mixing ratio (volume ratio) of Ag and Si.

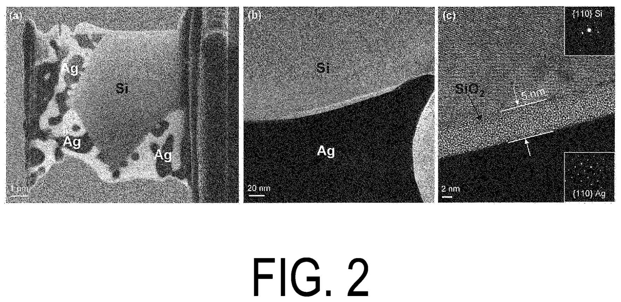

Note that the content proportion of the silicon particles with respect to the total amount of the silver flake powder and the silicon particles in the paste was 20 vol.%. Furthermore, a cross section of the test sample after the sintering was exposed and observed by an FE-SEM at a magnification of 50000 times. Then, a representative interface was observed by a TEM at a magnification of 100000 times, and thus it was confirmed that an interface was formed by the Si and the Ag at an atomic level. Furthermore, 15% of the surfaces of the silicon particles formed an interface with the silver particles. FIG. 2 shows a cross-sectional TEM image of the test sample obtained in Example 1.

Example 2

92 parts by mass of silver flake powder (trade name "AgC-239") and 8 parts by mass of silicon (Si) particles (trade name "Metal Silicon Powder") were mixed. Then, with respect to 100 parts by mass of the powder mixture, 25 parts by mass of a solvent (trade name "DPNP") was added and mixed, and thus "Si-Ag paste-2A" was obtained. This paste had a viscosity appropriate for use as a bonding paste.

By using the "Si-Ag paste-2A" described above, a test sample (bonded structure) having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 $\mu$m/s) between the Si die and the copper substrate was measured in the same manner as in Comparative Example 1, and the shear strength was 180 N. As described above, Example 2 exhibited a high shear strength compared to Comparative Example 5 having the same mixing ratio (volume ratio) of Ag and Si.

Note that the content proportion of the silicon particles with respect to the total amount of the silver flake powder and the silicon particles in the paste was 27 vol.%. Furthermore, a cross section of the test sample after the sintering was exposed and observed by an FE-SEM at a magnification of 50000 times. Then, a representative interface was observed by a TEM at a magnification of 100000 times, and thus it was confirmed that an interface was formed by the Si and the Ag at an atomic level. Furthermore, 20% of the surfaces of the silicon particles formed an interface with the silver particles.

Example 3

90 parts by mass of silver flake powder (trade name "AgC-239") and 10 parts by mass of silicon (Si) particles (trade name "Metal Silicon Powder") were mixed. Then, with respect to 100 parts by mass of the powder mixture, 25 parts by mass of a solvent (trade name "DPNP") was added and mixed, and thus "Si-Ag paste-3A" was obtained. This paste had a viscosity appropriate for use as a bonding paste.

By using the "Si-Ag paste-3A" described above, a test sample having a layer structure of Si die/Si-Ag paste/copper substrate was produced in the same manner as in Comparative Example 1. This test sample was heated in an air atmosphere, at a pressure (gauge pressure) of 2.0 MPa and a temperature of 250°C for 60 minutes by using a reflow furnace, and thus the Si-Ag paste was sintered (die-bonded). To determine the bonding strength between the Si die and the copper substrate in the test sample after the sintering, the shear strength (shear head speed: 50 μm/s) between the Si die and the copper substrate was measured in the same manner as in Comparative Example 1, and the shear strength was 150 N. As described above, Example 3 exhibited a high shear strength compared to Comparative Example 4 having the same mixing ratio (volume ratio) of Ag and Si.

Note that the content proportion of the silicon particles with respect to the total amount of the silver flake powder and the silicon particles in the paste was 34 vol.%. Furthermore, a cross section of the test sample after the sintering was exposed and observed by an FE-SEM at a magnification of 50000 times. Then, a representative interface was observed by a TEM at a magnification of 100000 times, and thus it was confirmed that an interface was formed by the Si and the Ag at an atomic level. Furthermore, 12% of the surfaces of the silicon particles formed an interface with the silver particles.

Hereinafter, variations of the invention according to the present disclosure will be described.

[Supplementary Note 1] A low-temperature-sinterable bonding material containing silver particles and silicon particles, greater than 50% of surfaces of the silicon particles being constituted by silicon atoms.

[Supplementary Note 2] The low-temperature-sinterable bonding material according to Supplementary Note 1, where 60% or greater of the silicon particles are constituted by silicon atoms.

[Supplementary Note 3] The low-temperature-sinterable bonding material according to Supplementary Note 1 or 2, where an average particle diameter of the silicon particles is from 0.05 to 40 μm.

[Supplementary Note 4] The low-temperature-sinterable bonding material according to any one of Supplementary Notes 1 to 3, where silver constituting the silver particles and silicon constituting the silicon particles form an interface at an atomic level by sintering.

[Supplementary Note 5] The low-temperature-sinterable bonding material according to any one of Supplementary Notes 1 to 4, where an average particle diameter of the silver particles is from 0.5 to 40 μm.

[Supplementary Note 6] The low-temperature-sinterable bonding material according to any one of Supplementary Notes 1 to 5, where the silver particles are in a flake shape.

[Supplementary Note 7] A low-temperature-sinterable bonding material containing silver particles and silicon particles, silver constituting the silver particles and silicon constituting the silicon particles forming an interface at an atomic level by sintering.

[Supplementary Note 8] The low-temperature-sinterable bonding material according to Supplementary Note 7, where 20% or greater of surfaces of the silicon particles form the interface with the silver particles by the sintering.

[Supplementary Note 9] The low-temperature-sinterable bonding material according to Supplementary Note 7 or 8, where 40% or greater of surfaces of the silicon particles form the interface with the silver particles by the sintering.

[Supplementary Note 10] A low-temperature-sinterable bonding material containing silver particles and silicon particles, an average particle diameter of the silicon particles being 1/20 or greater of an average particle diameter of the silver particles, and a content proportion of the silicon particles with respect to a total amount of the silver particles and the silicon particles being from 10 to 70 vol.%.

[Supplementary Note 11] The low-temperature-sinterable bonding material according to Supplementary Note 10, where an average particle diameter of the silicon particles is from 0.05 to 40 μm.

[Supplementary Note 12] The low-temperature-sinterable bonding material according to Supplementary Note 10 or 11, where an average particle diameter of the silver particles is from 0.1 to 50 μm.

[Supplementary Note 13] The low-temperature-sinterable bonding material according to any one of Supplementary Notes 1 to 12, where the low-temperature-sinterable bonding material is a paste or a sheet.

[Supplementary Note 14] A bonded structure comprising an object to be bonded, a substrate, and a silver bonding layer containing a sintered body of the low-temperature-sinterable bonding material described in any one of Supplementary Notes 1 to 12, the object being bonded to the substrate via the silver bonding layer.

Reference Signs List

1 Bonded structure
10 Substrate
20 Silver bonding layer
30 Member to be bonded

**Claims**

1. A low-temperature-sinterable bonding material comprising silver particles and silicon particles, greater than 50% of surfaces of the silicon particles being constituted by silicon atoms.

2. The low-temperature-sinterable bonding material according to claim 1, wherein 60% or greater of the silicon particles are constituted by silicon atoms.

3. The low-temperature-sinterable bonding material according to claim 1, wherein an average particle diameter of the silicon particles is from 0.05 to 40 $\mu$m.

4. The low-temperature-sinterable bonding material according to claim 1, wherein silver constituting the silver particles and silicon constituting the silicon particles form an interface at an atomic level by sintering.

5. The low-temperature-sinterable bonding material according to claim 1, wherein an average particle diameter of the silver particles is from 0.5 to 40 $\mu$m.

6. The low-temperature-sinterable bonding material according to claim 1, wherein the silver particles are in a flake shape.

7. A low-temperature-sinterable bonding material comprising silver particles and silicon particles, silver constituting the silver particles and silicon constituting the silicon particles forming an interface at an atomic level by sintering.

8. The low-temperature-sinterable bonding material according to claim 7, wherein 10% or greater of surfaces of the silicon particles form the interface with the silver particles by the sintering.

9. The low-temperature-sinterable bonding material according to claim 7, wherein 40% or greater of surfaces of the silicon particles form the interface with the silver particles by the sintering.

10. A low-temperature-sinterable bonding material comprising silver particles and silicon particles, an average particle diameter of the silicon particles being 1/20 or greater of an average particle diameter of the silver particles, and a content proportion of the silicon particles with respect to a total amount of the silver particles and the silicon particles being from 10 to 70 vol.%.

11. The low-temperature-sinterable bonding material according to claim 10, wherein an average particle diameter of the silicon particles is from 0.05 to 40 $\mu$m.

12. The low-temperature-sinterable bonding material according to claim 10, wherein an average particle diameter of the silver particles is from 0.1 to 50 $\mu$m.

13. The low-temperature-sinterable bonding material according to any one of claims 1 to 12, wherein the low-temperature-sinterable bonding material is a paste or a sheet.

14. A bonded structure comprising an object to be bonded, a substrate, and a silver bonding layer containing a sintered body of the low-temperature-sinterable bonding material described in any one of claims 1 to 12, the object being bonded to the substrate via the silver bonding layer.

FIG. 1

# FIG. 2

## INTERNATIONAL SEARCH REPORT

International application No.

**PCT/JP2024/015092**

### A. CLASSIFICATION OF SUBJECT MATTER

*H01L 21/52*(2006.01)i; *H01B 1/00*(2006.01)i; *H01B 1/22*(2006.01)i
FI:   H01L21/52 E; H01B1/22 D; H01B1/00 L

According to International Patent Classification (IPC) or to both national classification and IPC

### B. FIELDS SEARCHED

Minimum documentation searched (classification system followed by classification symbols)

H01L21/52; H01B1/00; H01B1/22

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2015/060173 A1 (HITACHI CHEMICAL COMPANY, LTD.) 30 April 2015 (2015-04-30)<br>paragraphs [0001], [0018], [0021]-[0024], [0038]-[0041], [0048], [0068], [0072] | 1-14 |
| A | JP 3-34211 A (SHINKU YAKIN KK) 14 February 1991 (1991-02-14) | 1-14 |
| A | WO 2021/039874 A1 (DAICEL CORP.) 04 March 2021 (2021-03-04) | 1-14 |
| A | JP 2012-515266 A (ROBERT BOSCH GMBH) 05 July 2012 (2012-07-05) | 1-14 |

☐ Further documents are listed in the continuation of Box C.     ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **24 June 2024** | **02 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

| International application No. |
| :--- |
| **PCT/JP2024/015092** |

| Patent document cited in search report | | | Publication date (day/month/year) | Patent family member(s) | | | Publication date (day/month/year) |
| :--- | :--- | :--- | :--- | :--- | :--- | :--- | :--- |
| WO | 2015/060173 | A1 | 30 April 2015 | JP | 2019-137920 | A | |
| | | | | TW | 201526029 | A | |
| JP | 3-34211 | A | 14 February 1991 | (Family: none) | | | |
| WO | 2021/039874 | A1 | 04 March 2021 | TW | 202126404 | A | |
| JP | 2012-515266 | A | 05 July 2012 | US | 2012/0003465 | A1 | |
| | | | | WO | 2010/081752 | A1 | |
| | | | | DE | 102009000192 | A1 | |
| | | | | CN | 102281973 | A | |

Form PCT/ISA/210 (patent family annex) (July 2022)

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023068160 A
- JP 2011080147 A
- WO 2021039874 A